# FASCICULE DE BREVET EUROPEEN

(11) **EP 3 650 957 B1**
(45) Date de publication et mention de la délivrance du brevet: **09.06.2021**
(21) Numéro de dépôt: 18204699.5
(22) Date de dépôt: 06.11.2018
(51) Int. Cl.: G04G 17/04, G04G 17/06

(54) **OBJET MUNI D'UN DISPOSITIF D'AFFICHAGE ÉLECTROOPTIQUE**
GEGENSTAND, DER MIT EINER ELEKTROOPTISCHEN ANZEIGEVORRICHTUNG AUSGESTATTET IST
OBJECT PROVIDED WITH AN ELECTRO-OPTICAL DISPLAY DEVICE

(43) Date de publication de la demande: 13.05.2020
(73) Titulaire: The Swatch Group Research and Development Ltd, 2074 Marin (CH)
(72) Inventeur: SCHINDLER, Axel, 3232 Ins (CH); HAMM, Alain, 2000 Neuchâtel (CH)
(74) Mandataire: ICB SA

(56) Documents cités:
- FR-A1- 2 867 285
- KR-A- 20170 026 007
- US-A1- 2015 029 829

## Description

### Domaine technique de l'invention

La présente invention concerne un objet muni d'un affichage électrooptique. Plus précisément, l'invention concerne un objet tel qu'une pièce d'horlogerie ou un téléphone intelligent qui comprend un cadre délimitant une ouverture fermée par une glace sous une surface inférieure de laquelle est agencé un dispositif d'affichage électrooptique.

### Arrière-plan technologique de l'invention

La présente invention concerne le domaine des dispositifs d'affichage électrooptiques. Par dispositif d'affichage électrooptique, on entend un dispositif d'affichage comprenant un élément optiquement actif dont les propriétés optiques sont modifiées par application d'une tension ou d'un courant électrique. Parmi les dispositifs d'affichage qui répondent à cette définition, on peut notamment citer les dispositifs d'affichage à cristal liquide (encore connus sous leur dénomination anglo-saxonne Liquid Crystal Display devices ou LCD devices), les cellules à diodes organiques électroluminescentes (également connues sous leur dénomination anglo-saxonne Organic Light Emitting Diode devices ou OLED devices), les dispositifs d'affichage électrochromiques ou bien encore les dispositifs d'affichage électrophorétiques.

Les dispositifs d'affichage électrooptiques auxquels la présente invention s'intéresse comprennent classiquement au moins un substrat qui sert de support à un élément optiquement actif disposé entre au moins une électrode et une contre-électrode correspondante et dont les propriétés optiques peuvent être modifiées par application d'une tension ou d'un courant électrique entre ces au moins une électrode et contre-électrode.

A titre d'exemple illustratif seulement, on peut envisager le cas d'un dispositif d'affichage à cristal liquide par exemple du type nématique en hélice (Twisted Nematic ou TN en terminologie anglo-saxonne) qui comprend un substrat avant qui s'étend parallèlement à et à distance d'un substrat arrière. Ces substrats avant et arrière sont réunis entre eux au moyen d'un mur de scellement qui délimite une enceinte étanche dans laquelle est confiné le cristal liquide. Des électrodes et des contre-électrodes sont structurées sur les faces en regard des substrats avant et arrière. Par application d'une tension électrique entre une électrode et une contre-électrode déterminées, il est possible de modifier les propriétés optiques du cristal liquide au point de croisement entre cette électrode et cette contre-électrode.

Pour assurer le bon fonctionnement d'un dispositif d'affichage à cristal liquide, il convient de relier les électrodes et les contres-électrodes de ce dernier à un dispositif électronique d'alimentation et de commande situé au moins pour partie à l'extérieur du dispositif d'affichage. A cette fin, l'un des deux substrats, habituellement le substrat arrière, est prévu plus grand que le substrat avant et l'on met à profit ce surcroît de surface pour prolonger par des pistes électriquement conductrices les contre-électrodes portées par le substrat arrière hors du cadre de scellement du dispositif d'affichage. De même, les électrodes portées par le substrat avant sont reportées sur le substrat arrière par exemple au moyen de billes conductrices de l'électricité dispersées dans le cadre de scellement. Ces billes électriquement conductrices sont en contact d'une part avec les électrodes, et d'autre part avec des pistes conductrices qui courent sur le substrat arrière et qui permettent de prolonger ces électrodes hors de l'enceinte étanche délimitée par ledit cadre de scellement. Grâce à des connecteurs électriques, il est possible de relier les pistes conductrices, et par voie de conséquence les électrodes et les contre-électrodes du dispositif d'affichage à cristal liquide, au dispositif électronique externe d'alimentation et de commande.

Il existe de nos jours de nombreuses applications dans lesquelles on souhaite fixer un dispositif d'affichage électrooptique tel qu'un dispositif d'affichage à cristal liquide du type succinctement décrit ci-dessus contre une glace. Parmi les exemples qui viennent immédiatement à l'esprit, on peut citer les pièces d'horlogerie telles que les montres-bracelets ou bien encore les téléphones portables. De tels objets portables comprennent un cadre (encore appelé « carrure » dans le cas particulier des montres-bracelets) qui délimite une ouverture fermée par une glace. Cette glace comporte une surface supérieure dirigée du côté d'un observateur et une surface inférieure, opposée à la surface supérieure, et contre laquelle est solidarisé par exemple un dispositif d'affichage à cristal liquide. Ce dispositif d'affichage à cristal liquide est destiné à afficher des informations qui vont être perceptibles par l'utilisateur à travers l'ouverture délimitée par le cadre de l'objet portable.

Le problème qui se pose à tous les concepteurs qui souhaitent équiper un objet, tel qu'une montre-bracelet ou un téléphone intelligent, d'un dispositif d'affichage électrooptique directement fixé contre la surface inférieure de la glace, réside dans l'obligation de devoir, pour des raisons esthétiques bien compréhensibles, cacher au regard de l'utilisateur tous les éléments de connexion électriques qui permettent de relier le dispositif d'affichage électrooptique à son dispositif électronique externe d'alimentation et de commande. La solution la plus répandue à l'heure actuelle pour résoudre ce problème consiste à donner au substrat avant par lequel le dispositif d'affichage électrooptique est solidarisé contre la surface inférieure de la glace une dimension égale ou sensiblement la même que celle de cette glace, et à prévoir un substrat arrière de plus grande dimension que le substrat avant afin de disposer de la surface suffisante pour pouvoir agencer tous les éléments nécessaires à la connexion électrique du dispositif d'affichage électrooptique à son dispositif électronique externe d'alimentation et de commande. La portion du substrat arrière qui excède les dimensions de la glace s'étend sous le cadre par définition opaque de l'objet portable et est donc invisible au regard de l'utilisateur.

Dans ces modes de réalisation de l'art antérieur, la surface active du dispositif d'affichage électrooptique, c'est-à-dire l'étendue sur laquelle un tel dispositif d'affichage électrooptique peut afficher des informations, est sensiblement égale à l'étendue de l'ouverture délimitée par le cadre de l'objet. On connaît déjà des objets tels qu'une montre-bracelet qui comprend deux dispositifs d'affichage superposés de type électrooptique. En effet, le dispositif d'affichage électrooptique supérieur est agencé de façon que, lorsqu'il n'affiche pas d'informations, il est semi-transparent et laisse voir les informations affichées par le dispositif d'affichage électrooptique inférieur. Cette solution semble par contre bien moins adaptée dans le cas où le dispositif d'affichage inférieur n'est pas un dispositif d'affichage électrooptique. Tel est par exemple le cas si l'objet tel qu'une montre-bracelet est équipé, par exemple, d'un cadran au-dessus duquel se déplacent des aiguilles indicatrices. En effet, comme le dispositif d'affichage électrooptique qui est agencé au-dessus du dispositif d'affichage à aiguille est disposé entre deux polariseurs, moins de 50% de la lumière extérieure qui tombe sur ce dispositif d'affichage électrooptique va pénétrer à l'intérieur de la boîte de la montre, de sorte que le cadran et les aiguilles qui se déplacent au-dessus de celui-ci vont paraître sombres et seront difficilement perceptibles par l'utilisateur. Il existe donc un besoin dans l'état de la technique pour un objet, en particulier un objet portable tel qu'une montre-bracelet ou un téléphone intelligent, comprenant un cadre qui délimite une ouverture à travers laquelle il soit possible de voir, non seulement les informations affichées par le dispositif d'affichage électrooptique, mais également les informations affichées par un second dispositif d'affichage agencé sous le dispositif d'affichage électrooptique, tout en masquant au regard de l'utilisateur les éléments de construction ainsi que les éléments de connexion électrique dont la vue nuirait à l'aspect esthétique de l'objet.

Le document FR2867285 A1 divulgue une montre hybride dont les aiguilles sont partiellement transparentes pour ne pas bloquer un afficheur LCD central.

### Résumé de l'invention

La présente invention a pour but de répondre aux besoins décrits ci-dessus ainsi qu'à d'autres encore en procurant un objet, en particulier un objet portable tel qu'une pièce d'horlogerie ou un téléphone intelligent, muni d'un premier dispositif d'affichage électrooptique et d'un second dispositif d'affichage agencé sous le dispositif d'affichage électrooptique, les informations affichées respectivement par le premier dispositif d'affichage électrooptique et par le second dispositif d'affichage étant perceptibles à travers l'ouverture délimitée par le cadre de l'objet. Bien entendu, tous les éléments nécessaires à la connexion électrique du premier dispositif d'affichage électrooptique à son dispositif électronique externe d'alimentation et de commande doivent rester imperceptibles au regard de l'utilisateur.

A cet effet, la présente invention concerne un objet, en particulier un objet portable tel qu'une pièce d'horlogerie ou un téléphone intelligent, cet objet comprenant un dispositif d'affichage électrooptique délimité extérieurement par un contour et qui est muni d'un élément optiquement actif dont les propriétés optiques peuvent être modifiées par application d'un courant ou d'une tension électrique entre au moins une électrode et une contre-électrode correspondante entre lesquelles l'élément optiquement actif est disposé, l'objet comprenant également une carrure qui délimite une ouverture fermée par une glace, la glace comprenant une surface supérieure et une surface inférieure sous laquelle est agencé le dispositif d'affichage électrooptique, l'objet comprenant aussi un dispositif électronique externe d'alimentation et de commande ainsi que des éléments pour la connexion électrique du dispositif d'affichage électrooptique au dispositif électronique externe d'alimentation et de commande, la glace étant pourvue d'un cadre opaque qui est ménagé à distance des bords de l'ouverture et qui recouvre le contour du dispositif d'affichage électrooptique de façon à masquer les éléments de connexion électrique, le dispositif d'affichage électrooptique définissant une zone active d'affichage qui est circonscrite par le cadre opaque, de sorte que, même lorsque le dispositif d'affichage électrooptique est activé et qu'il affiche des informations, il subsiste entre le cadre opaque et les bords de l'ouverture une zone transparente.

Selon un mode particulier de réalisation de l'invention, l'objet comprend un second dispositif d'affichage d'une information agencé sous le dispositif d'affichage électrooptique et au moins partiellement visible à travers la zone transparente.

Grâce à ces caractéristiques, la présente invention procure un objet, notamment un objet portable tel qu'une montre-bracelet ou un téléphone intelligent, muni d'un dispositif d'affichage électrooptique dont une zone active d'affichage, définie par un élément optiquement actif dont les propriétés optiques peuvent être modifiées par application d'un courant ou d'une tension électrique, est délimitée par un cadre opaque qui masque les éléments de connexion électrique du dispositif d'affichage électrooptique. Par conséquent, même lorsque la zone active d'affichage affiche des informations, il subsiste entre le cadre opaque et le bord de l'ouverture délimitée par la carrure de l'objet, une zone transparente dépourvue de toute information affichée que l'on peut mettre à profit pour rendre visible, par exemple, un second dispositif d'affichage disposé sous le dispositif d'affichage électrooptique.

Un exemple qui illustre bien les possibilités offertes par la présente invention est celui d'une montre-bracelet équipée d'un dispositif d'affichage électrooptique conformément à la présente invention et comprenant en outre un cadran muni d'aiguilles agencé sous le dispositif d'affichage électrooptique. Grâce aux caractéristiques de l'invention, l'utilisateur de la montre-bracelet voit ainsi simultanément à travers la glace de sa montre les informations digitales affichées par la zone active du dispositif d'affichage électrooptique, et les informations analogiques affichées par les aiguilles qui se déplacent au-dessus du cadran. Grâce à l'invention, on obtient donc une montre hybride munie d'un affichage du type « écran » et d'un affichage analogique du type « aiguille » dont l'aspect est original et innovant. On prendra cependant soin de bien noter que la présente invention n'est pas limitée à l'utilisation d'un dispositif d'affichage analogique disposé sous le dispositif d'affichage électrooptique, et que l'on peut très bien envisager de combiner un premier et un second dispositif d'affichage électrooptique entre eux, le second dispositif d'affichage électrooptique étant alors adapté pour afficher des informations dans la zone transparente située entre le bord de la carrure et le cadre opaque. On pourra ainsi au choix activer uniquement le premier dispositif d'affichage électrooptique fixé sous la glace, ou bien activer uniquement le second dispositif d'affichage électrooptique disposé sous le premier, ou bien activer les premier et second dispositifs d'affichage électrooptiques simultanément.

### Brève description des figures

D'autres caractéristiques et avantages de la présente invention ressortiront plus clairement de la description détaillée qui suit d'un exemple de réalisation d'un objet portable du type montre-bracelet selon l'invention, cet exemple étant donné à titre purement illustratif et non limitatif seulement en liaison avec le dessin annexé sur lequel :

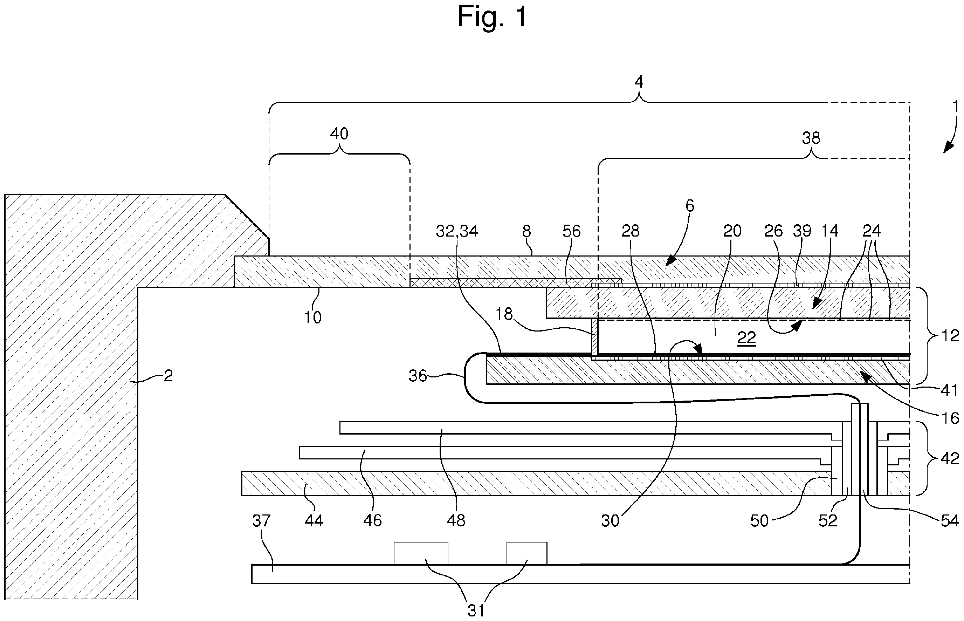

- la figure 1 est une vue partielle en coupe d'une première forme d'exécution d'une boîte de montre selon l'invention dont une carrure délimite une ouverture fermée par une glace contre la surface inférieure de laquelle est solidarisé un dispositif d'affichage électrooptique du type dispositif d'affichage à cristal liquide, un second dispositif d'affichage comprenant un premier canon portant une première aiguille et un second canon agencé concentriquement à l'intérieur du premier canon et portant une seconde aiguille étant disposé sous le dispositif d'affichage électrooptique, ce dispositif d'affichage électrooptique étant relié à un dispositif électronique externe d'alimentation et de commande via un circuit imprimé flexible encore connu sous sa dénomination anglo-saxonne Flexible Printed Circuit ou FPC qui est passé dans un tube creux agencé à l'intérieur du second canon ;

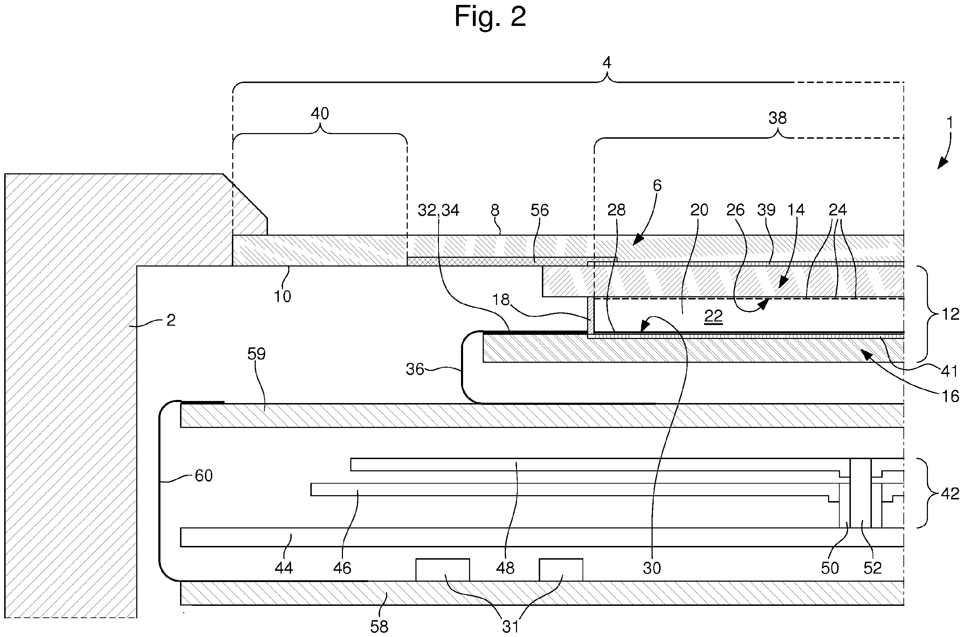

- la figure 2 est une vue partielle en coupe d'une deuxième forme d'exécution d'une boîte de montre selon l'invention dans laquelle le dispositif d'affichage électrooptique est relié au moyen d'un premier et d'un second circuit imprimé flexible à son dispositif électronique externe d'alimentation et de commande agencé sous le second dispositif d'affichage via une carte de circuit imprimé transparente agencée sous le dispositif d'affichage électrooptique, le second dispositif d'affichage étant agencé sous la carte de circuit imprimé transparente ;

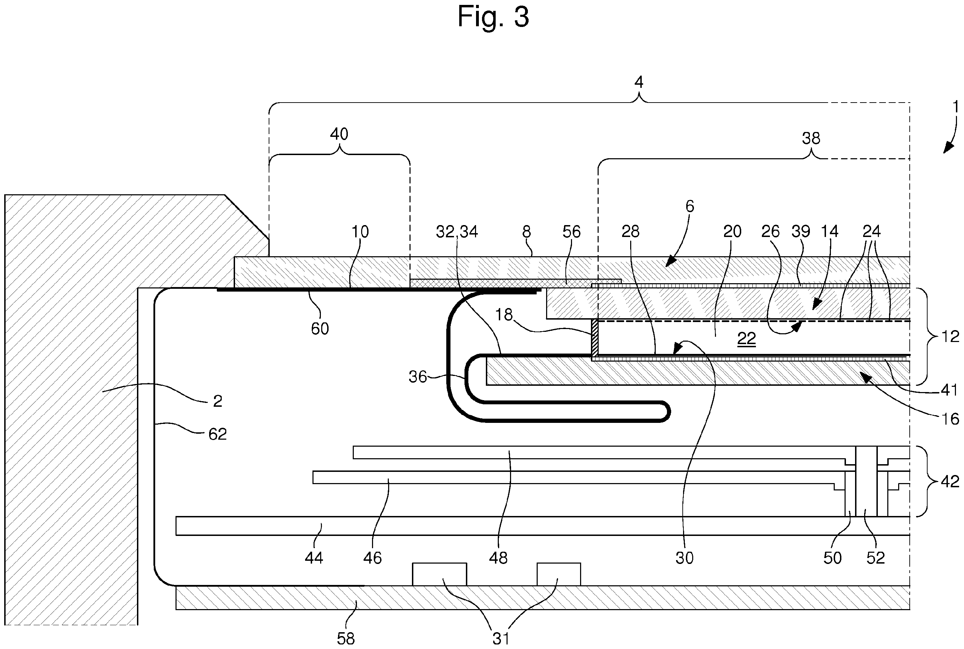

- la figure 3 est une vue partielle en coupe d'une troisième forme d'exécution d'une boîte de montre selon l'invention dans laquelle des pistes conductrices transparentes sont structurées sur la surface inférieure de la glace, le dispositif d'affichage électrooptique étant relié à ces pistes conductrices transparentes au moyen d'un premier circuit imprimé flexible, les pistes conductrices transparentes étant elles-mêmes reliées au moyen d'un deuxième circuit imprimé flexible au dispositif électronique externe d'alimentation et de commande du dispositif d'affichage électrooptique, un second dispositif d'affichage étant disposé sous le dispositif d'affichage électrooptique ;

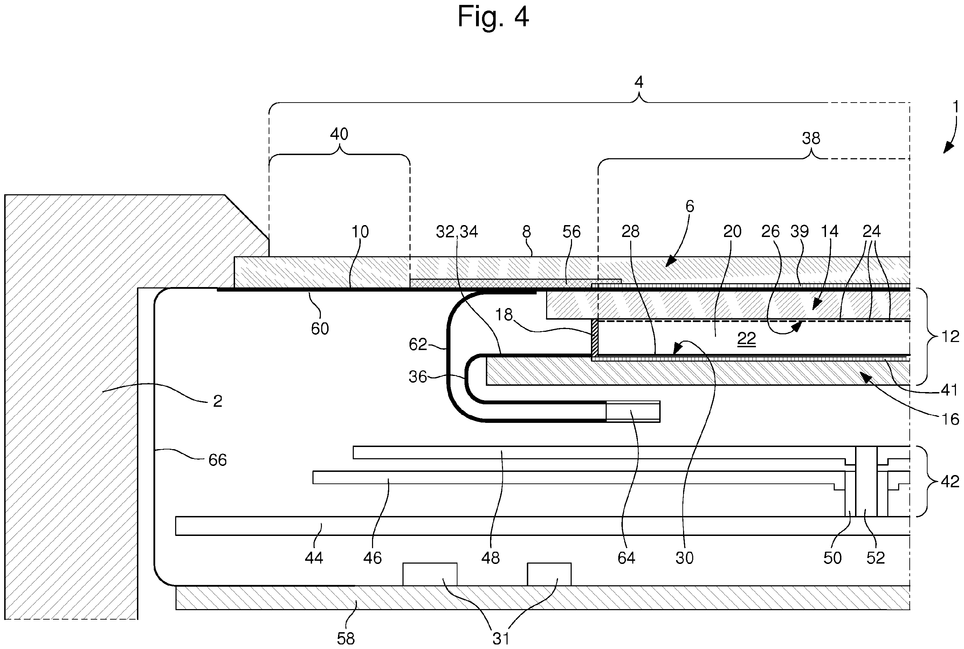

- la figure 4 est une vue partielle en coupe d'une quatrième forme d'exécution d'une boîte de montre selon l'invention qui diffère de la forme d'exécution illustrée à la figure 3 uniquement en ce que le premier circuit imprimé flexible est scindé en deux parties reliées entre elles au moyen d'un connecteur électrique pour faciliter le montage ;

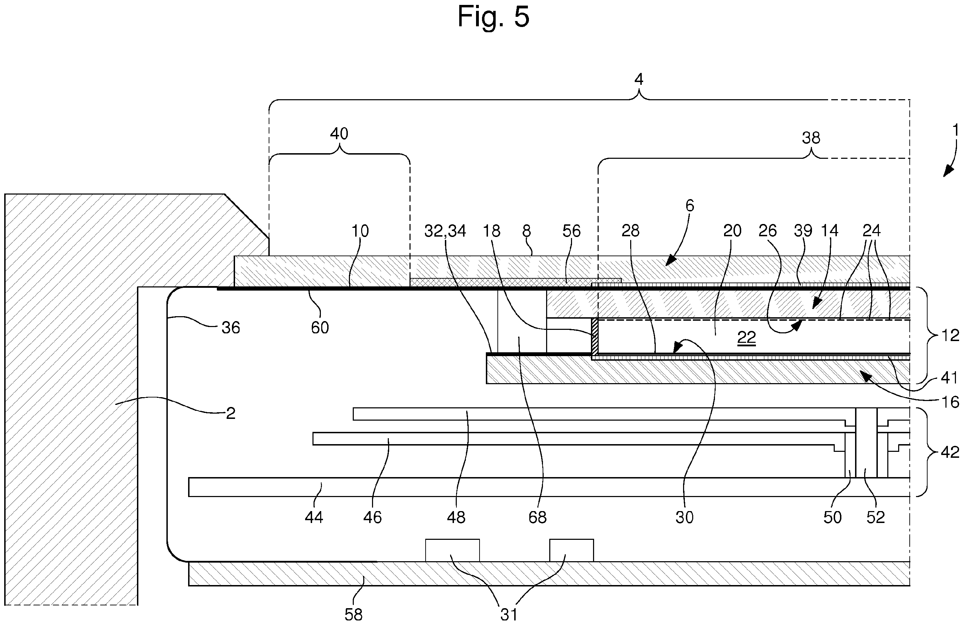

- la figure 5 est une vue partielle en coupe d'une cinquième forme d'exécution d'une boîte de montre selon l'invention dans laquelle un connecteur souple formé d'une alternance de feuilles électriquement conductrices et de feuilles élastomères isolantes permet de relier un dispositif d'affichage électrooptique à des pistes conductrices transparentes structurées sur la surface inférieure de la glace, un circuit imprimé flexible permettant de relier les pistes conductrices transparentes à un dispositif externe d'alimentation et de commande du dispositif d'affichage électrooptique, un second dispositif d'affichage étant disposé sous le dispositif d'affichage électrooptique ;

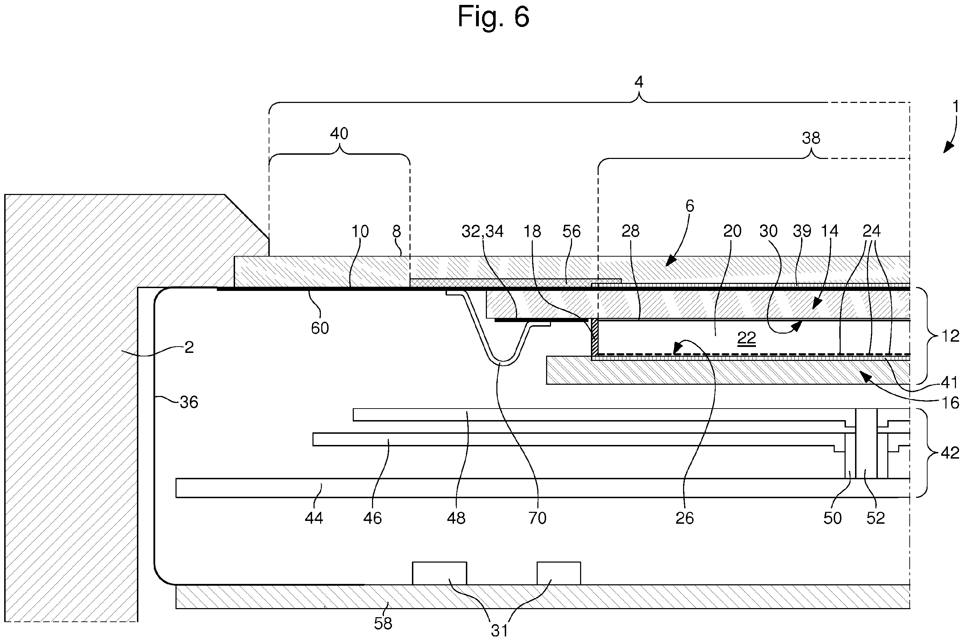

- la figure 6 est une vue partielle en coupe d'une sixième forme d'exécution d'une boîte de montre selon l'invention dans laquelle le dispositif d'affichage électrooptique est fixé par son substrat avant contre la surface inférieure de la glace et est relié par un procédé de connexion par fils à des pistes conductrices transparentes structurées sur la surface inférieure de la glace, un circuit imprimé flexible permettant de relier les pistes conductrices transparentes au dispositif externe d'alimentation et de commande du dispositif d'affichage électrooptique, un second dispositif d'affichage étant disposé sous le dispositif d'affichage électrooptique, et

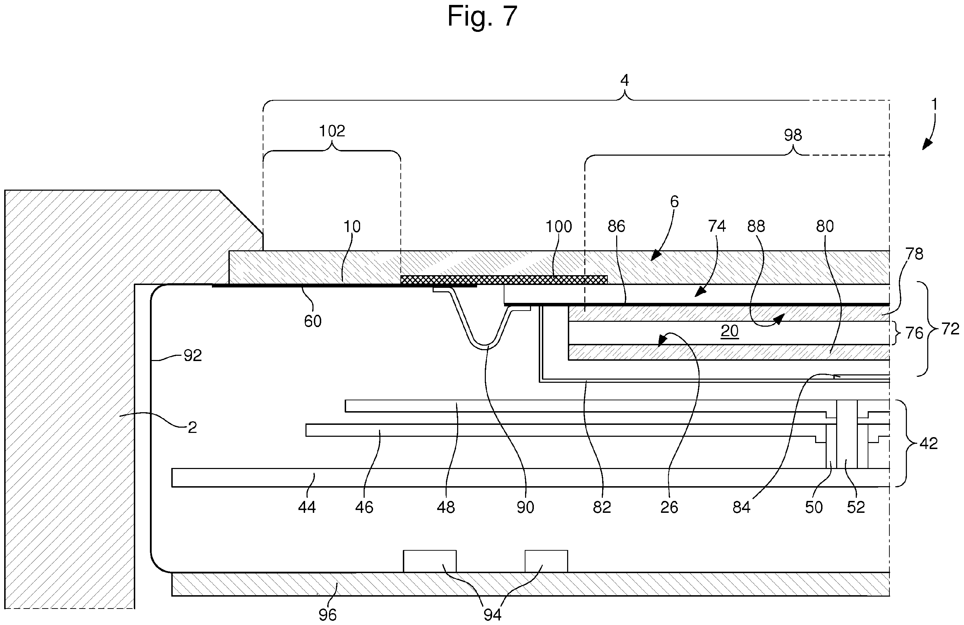

- la figure 7 est une vue analogue à celle de la figure 6 sur laquelle le dispositif d'affichage électrooptique est du type OLED.

### Description détaillée d'un mode de réalisation de l'invention

La présente invention procède de l'idée générale inventive qui consiste à disposer un dispositif d'affichage électrooptique sous la surface inférieure d'une glace obturant une ouverture délimitée par une carrure d'un objet, notamment un objet portable tel qu'une montre-bracelet ou un téléphone intelligent. L'originalité de l'objet selon l'invention est qu'il est prévu de munir la glace d'un cadre opaque qui s'étend à distance des bords de l'ouverture délimitée par la carrure et qui recouvre le dispositif d'affichage électrooptique à sa périphérie, de façon à masquer les éléments nécessaires pour connecter électriquement le dispositif d'affichage électrooptique à son dispositif électronique externe d'alimentation et de commande. La zone active d'affichage du dispositif d'affichage électrooptique étant circonscrite par le cadre opaque, il subsiste, entre le cadre opaque et le bord de l'ouverture délimitée par la carrure de l'objet, une zone transparente dépourvue de toute information affichée. Par conséquent, même lorsque le dispositif d'affichage électrooptique est activé et qu'il affiche des informations, il subsiste entre sa zone active d'affichage et les bords de la carrure de l'objet une zone transparente dépourvue de toute information affichée à travers laquelle il est possible de voir, par exemple, un second dispositif d'affichage d'une information agencé sous le dispositif d'affichage électrooptique. Ce second dispositif d'affichage d'une information peut être de tout type : il peut s'agir simplement d'un motif décoratif ; il peut également s'agir d'un second dispositif d'affichage électrooptique. Selon une forme spéciale d'exécution de l'invention, le second dispositif d'affichage est un cadran au-dessus duquel se déplacent des aiguilles. Grâce à l'invention, on obtient donc une montre hybride munie d'un affichage du type « écran » et d'un affichage analogique dont l'aspect est original et innovant.

La présente invention va être décrite en liaison avec un objet portable du type montre-bracelet équipé d'un dispositif d'affichage électrooptique du type dispositif d'affichage à cristal liquide. Il va de soi que cet exemple est donné à titre purement illustratif et non limitatif seulement et que l'objet peut être autre chose qu'une pièce d'horlogerie. Il s'agit très généralement de tout type d'objet comme un téléphone ou un ordinateur portable comprenant une carrure qui délimite une ouverture fermée par une glace à travers laquelle des informations affichées par le dispositif d'affichage électrooptique sont perceptibles. De même, le choix du dispositif d'affichage électrooptique n'est pas limité aux dispositifs d'affichage à cristal liquide et s'étend notamment aux dispositifs d'affichage du type à diodes organiques électroluminescentes ainsi qu'aux dispositifs d'affichage électrophorétiques et aux dispositifs d'affichage électrochromiques. En effet, ces différents types de dispositifs d'affichage électrooptiques comprennent tous au moins un substrat qui sert de support à un élément optiquement actif (cristal liquide par exemple nématique en hélice ou super nématique en hélice ou bien encore à alignement vertical pour un dispositif d'affichage à cristal liquide, couches actives d'injection de trous, de transport de trous et de transport d'électrons pour un dispositif d'affichage à diodes organiques électroluminescentes, particules noires et blanches ou particules couleurs dispersées dans un fluide dans le cas des dispositifs d'affichage électrophorétiques, électrolyte liquide ou solide dans le cas des dispositifs d'affichage électrochromiques), et des jeux d'électrodes et de contre-électrodes servant à modifier les propriétés optiques de l'élément optiquement actif par application d'une tension ou d'un courant électrique.

On notera qu'au sens de la présente invention, on entend par zone active d'affichage d'un dispositif d'affichage électrooptique la portion utile de la surface avant du dispositif d'affichage électrooptique sur laquelle des éléments d'information peuvent être affichés. A titre d'exemple, dans le cas d'un dispositif d'affichage électrooptique du type à cristal liquide nématique en hélice, on a affaire à deux substrats avant et arrière qui s'étendent parallèlement à et à distance l'un de l'autre et qui sont réunis entre eux par un mur de scellement qui délimite une enceinte étanche pour le confinement du cristal liquide. Un film polariseur avant est fixé sur le dessus du substrat avant et sa direction de polarisation forme un angle de 90° avec la direction de polarisation d'un film polariseur arrière fixé sur le dessous du substrat arrière. On dit alors que les polariseurs sont croisés. Dans ce cas, les informations affichées par le dispositif d'affichage électrooptique dans sa zone active d'affichage vont apparaître en sombre sur un fond transparent. Pour que la zone active d'affichage apparaisse opaque, on peut combiner le film polariseur arrière avec un réflecteur ou bien prévoir un dispositif de rétroéclairage opaque sur le dessous du substrat arrière. En lieu et place du dispositif de rétroéclairage, un film opaque peut également convenir.

Il est également possible que les polariseurs soient parallèles, c'est-à-dire que leurs directions de polarisation soient parallèles entre elles. Un autre mode de réalisation encore consiste à combiner un polariseur circulaire fixé sur le dessus du substrat avant avec un réflecteur métallique agencé à l'intérieur du dispositif d'affichage à cristal liquide, sur le dessus du substrat arrière. La zone active d'affichage est donc définie comme le volume de cristal liquide pris en sandwich entre le film polariseur avant et le film polariseur arrière ou entre le film polariseur circulaire et le réflecteur métallique.

Désignée dans son ensemble par la référence numérique générale 1, la boîte de montre-bracelet représentée seulement en partie et en coupe sur la figure 1 comprend une carrure 2. Cette carrure 2 délimite une ouverture 4, par exemple circulaire, qui est fermée de manière parfaitement étanche par une glace 6. Cette glace 6 comprend une surface supérieure 8 tournée du côté de l'utilisateur, et une surface inférieure 10, opposée à la surface supérieure 8 et tournée du côté de l'intérieur de la boîte 1 de montre-bracelet. Un dispositif d'affichage électrooptique, en l'occurrence un dispositif d'affichage à cristal liquide 12, comprend un substrat avant 14 transparent fixé par tout moyen approprié contre la surface inférieure 10 de la glace 6. Ce substrat avant 14 s'étend parallèlement à et à distance d'un substrat arrière 16 également transparent. Les substrats avant 14 et arrière 16 sont réunis entre eux au moyen d'un mur de scellement 18 qui délimite une enceinte étanche 20 pour le confinement d'un cristal liquide 22. Le dispositif d'affichage à cristal liquide 12 est par exemple solidarisé par laminage au moyen d'une colle optiquement transparente (Optical Clear Adhesive ou OCA en terminologie anglo-saxonne) contre la surface inférieure 10 de la glace 6. La colle optiquement transparente a pour avantage d'éviter les problèmes de réflexions optiques parasites à l'interface entre la glace 6 et le dispositif d'affichage à cristal liquide 12. Des électrodes 24 réalisées en un matériau transparent électriquement conducteur tel que de l'oxyde d'étain-indium (Indium Tin Oxyde ou ITO en terminologie anglo-saxonne) sont structurées sur une face inférieure 26 du substrat avant 14 du dispositif d'affichage à cristal liquide 12, tandis que des contre-électrodes 28, elles aussi réalisées en un matériau transparent électriquement conducteur, sont structurées sur une face supérieure 30 du substrat arrière 16. On notera que, dans le cas d'un dispositif d'affichage à cristal liquide de type réflectif, les contre-électrodes peuvent être réalisées en un matériau électriquement conducteur qui présente un aspect miroir. Les électrodes 24 et les contre-électrodes 28 sont agencées de part et d'autre de la couche de cristal liquide 22. Par application d'une tension électrique appropriée entre une électrode et une contre-électrode données, on modifie les propriétés optiques du cristal liquide 22 au point de croisement entre l'électrode et la contre-électrode considérées.

Les dimensions du substrat avant 14 du dispositif d'affichage à cristal liquide 12 sont inférieures à celles de la glace 6. Quant au substrat arrière 16, ses dimensions sont plus grandes que celles du substrat avant 14 mais également plus petites que celles de la glace 6. Il faut en effet avoir présent à l'esprit que les électrodes 24 et les contre-électrodes 28 doivent être reliées à un dispositif électronique externe 31 d'alimentation et de commande. A cette fin, le substrat arrière 16 est prévu plus grand que le substrat avant 14 et l'on met à profit ce surcroît de surface pour prolonger par des premières pistes électriquement conductrices 32 réalisées en un matériau transparent électriquement conducteur tel que de l'oxyde d'étain-indium ou ITO les contre-électrodes 28 portées par le substrat arrière 16 hors du mur de scellement 18 du dispositif d'affichage à cristal liquide 12. De même, les électrodes 24 portées par le substrat avant 14 sont reportées sur le substrat arrière 16 par exemple au moyen de billes électriquement conductrices et dispersées dans la matière du mur de scellement 18. Ces billes électriquement conductrices mettent en contact les électrodes 24 avec des secondes pistes conductrices 34 qui courent sur le substrat arrière 16 et qui permettent de prolonger ces électrodes 24 hors de l'enceinte étanche délimitée par le mur de scellement 18. Grâce à un circuit imprimé flexible 36, encore connu sous sa dénomination anglo-saxonne Flexible Printed Circuit ou FPC, il est possible de relier les pistes conductrices 32, 34, et par voie de conséquence les électrodes 24 et les contre-électrodes 28 du dispositif d'affichage à cristal liquide 12, au dispositif électronique externe 31 d'alimentation et de commande agencé sur une carte de circuit imprimé 37.

Comme déjà indiqué ci-dessus, la zone active d'affichage 38 du dispositif d'affichage à cristal liquide 12 est définie par le volume du cristal liquide 22 confiné à l'intérieur du périmètre du mur de scellement 18 et qui se trouve compris entre un polariseur supérieur 39 et un polariseur inférieur 41. Ces polariseurs 39, 41 peuvent être croisés, c'est-à-dire que leurs directions de polarisation forment un angle droit, ou bien parallèles, c'est-à-dire que leurs directions de polarisation s'étendent parallèlement entre elles. Conformément à l'invention, et comme cela ressort de la figure 1 annexée à la présente demande de brevet, l'étendue de cette zone active d'affichage 38 est inférieure à la surface de la glace 6. Par conséquent, même lorsque le dispositif d'affichage à cristal liquide 12 est activé et qu'il affiche des informations, il subsiste entre sa zone active d'affichage 38 et les bords de l'ouverture 4 délimitée par la carrure 2 de la montre-bracelet une zone transparente 40 dépourvue de toute information affichée à travers laquelle il est possible de voir un second dispositif d'affichage 42 d'une information agencé sous le dispositif d'affichage à cristal liquide 12. Ce second dispositif d'affichage 42 d'une information peut être de tout type : il peut s'agir simplement d'un motif décoratif ; il peut également s'agir d'un second dispositif d'affichage électrooptique. Selon une forme spéciale d'exécution de l'invention illustrée sur la figure 1, le second dispositif d'affichage 42 agencé sous le dispositif d'affichage à cristal liquide 12 est formé d'un cadran 44 au-dessus duquel se déplacent des première et seconde aiguilles 46 et 48. Grâce à l'invention, on obtient donc une montre hybride munie d'un affichage du type « écran » et d'un affichage analogique dont l'aspect est original et innovant.

La première aiguille 46 est portée par un premier canon 50, et la seconde aiguille 48 est portée par un second canon 52 agencé concentriquement à l'intérieur du premier canon 50. Un tube creux 54 est agencé à l'intérieur du second canon 52. Ce tube creux 54 est prévu pour permettre le passage du circuit imprimé flexible 36 qui relie les pistes conductrices 32, 34 et, par voie de conséquence, les électrodes 24 et les contre-électrodes 28 du dispositif d'affichage à cristal liquide 12, au dispositif électronique externe 31 d'alimentation et de commande agencé sur la carte de circuit imprimé 37 qui est avantageusement disposée sous le second dispositif d'affichage 42. La présence du tube creux 54 dans lequel le circuit imprimé flexible 36 est passé permet d'éviter que ce circuit imprimé flexible 36 ne gêne la rotation des première et seconde aiguilles 46, 48 et ne puisse être perçu à travers la zone transparente 40.

Selon l'invention, la glace 6 est pourvue d'un cadre opaque 56 qui est ménagé à distance des bords de l'ouverture 4 et qui définit la surface utile à travers laquelle les informations affichées par le dispositif d'affichage à cristal liquide 12 sont perceptibles par l'utilisateur. Le cadre opaque 56 recouvre le dispositif d'affichage à cristal liquide 12 à sa périphérie de façon à masquer les éléments de connexion électriques, en particulier le circuit imprimé flexible 36, ainsi que le mur de scellement 18 et les bords des polariseurs supérieur 39 et inférieur 41. Le second dispositif d'affichage 42 reste donc partiellement visible à travers la zone transparente 40 qui est bordée à l'extérieur par les bords de la carrure 2 et à l'intérieur par le cadre opaque 56. Par cadre opaque, on entend un cadre qui ne laisse pas passer la lumière et qui masque donc complètement les éléments de connexion électrique du dispositif d'affichage à cristal liquide 12 au regard de l'utilisateur. A titre d'exemple uniquement, le cadre opaque 56 peut être une couche de peinture déposée par tampographie ou par sérigraphie. On peut également envisager d'usiner dans la glace 6 une rainure dont la géométrie correspond à celle du cadre opaque 56 recherché, et combler cette rainure avec un dépôt d'émail. Le cadre opaque 56 peut aussi être réalisé au moyen d'une couche mince métallique ou d'un film laminé sur la glace 6.

Dans tout ce qui suit, les éléments identiques à ceux décrits ci-dessus en liaison avec la figure 1 seront désignés par les mêmes références numériques.

A la figure 2, les pistes conductrices 32, 34 et, par voie de conséquence, les électrodes 24 et les contres-électrodes 28 du dispositif d'affichage à cristal liquide 12, sont reliées au dispositif électronique externe 31 d'alimentation et de commande qui est agencé sur une carte de circuit imprimé 58 disposée sous le cadran 44 grâce à un premier circuit imprimé flexible 36 qui s'étend entre le dispositif d'affichage à cristal liquide 12 et une carte de circuit imprimé transparente 59 disposée sous le dispositif d'affichage à cristal liquide 12 et sur laquelle sont structurées des pistes conductrices transparentes par exemple réalisées en oxyde d'étain-indium, encore connu sous sa dénomination anglo-saxonne Indium-Tin-Oxyde ou ITO, tandis qu'un second circuit imprimé flexible 60 relie la carte de circuit imprimé transparente 59 à la carte de circuit imprimé 58 sur laquelle est agencé le dispositif électronique externe 31 d'alimentation et de commande. On comprendra que l'on met à profit la présence du cadre opaque 56, de la zone active d'affichage 38 du dispositif d'affichage à cristal liquide 12 et du cadran 44 pour masquer au regard de l'utilisateur le circuit imprimé flexible 36, les différents composants du dispositif électronique externe 31 d'alimentation et de commande et, plus, généralement tous les éléments de connexion électrique. Le second dispositif d'affichage 42 qui, dans l'exemple représenté à titre non limitatif, comprend un cadran 44 au-dessus duquel se déplacent des première et seconde aiguilles 46 et 48, est agencé sous la carte de circuit imprimé 58 de façon à être partiellement visible à travers la zone transparente 40.

A la figure 3, des pistes conductrices transparentes 60 sont structurées sur la surface inférieure 10 de la glace 6. Selon une variante, les pistes conductrices transparentes 60 sont structurées sur un film souple qui est laminé contre la surface inférieure 10 de la glace 6. On sait d'autre part de ce qui précède que les électrodes 24 portées par le substrat avant 14 du dispositif d'affichage à cristal liquide 12 sont reportées sur le substrat arrière 16 de ce même dispositif d'affichage à cristal liquide 12. En utilisant un premier circuit imprimé flexible 36 judicieusement masqué par le cadre opaque 56 et relié aux pistes conductrices 32, 34 portées par la face supérieure 30 du substrat arrière 16 du dispositif d'affichage à cristal liquide 12, on relie les électrodes 24 et les contre-électrodes 28 aux pistes conductrices transparentes 60. Ensuite, au moyen d'un second circuit imprimé flexible 62 fixé sur la surface inférieure 10 de la glace 6 et masqué par la carrure 2, on relie les pistes conductrices transparentes 60 au dispositif électronique externe 31 d'alimentation et de commande du dispositif d'affichage à cristal liquide 12.

A la figure 4, un premier circuit imprimé flexible 36 relié aux pistes conductrices 32, 34 portées par la face supérieure 30 du substrat arrière 16 du dispositif d'affichage à cristal liquide 12 permet de raccorder les électrodes 24 et les contre-électrodes 28 aux pistes conductrices transparentes 60 structurées sur la surface inférieure 10 de la glace 6 via un second circuit imprimé flexible 62 avec interposition d'un connecteur électrique 64 qui sert à faciliter les opérations de montage entre les circuits imprimés flexibles 36 et 60. Ensuite, au moyen d'un troisième circuit imprimé flexible 66 fixé sur la surface inférieure 10 de la glace 6 et masqué par la carrure 2, on relie les pistes conductrices transparentes 60 au dispositif électronique externe 31 d'alimentation et de commande du dispositif d'affichage à cristal liquide 12. On notera que les circuits imprimés flexibles 36 et 62 ainsi que le connecteur électrique 64 sont judicieusement masqués par le cadre opaque 56 et le dispositif d'affichage à cristal liquide 12.

A la figure 5, un connecteur souple 68 formé d'une alternance de feuilles électriquement conductrices et de feuilles élastomères isolantes, notamment connu sous sa dénomination commerciale connecteur zebra®, est disposé entre le substrat arrière 16 et la glace 6. D'autres formes de réalisation du connecteur souple 68 telles qu'une matrice en silicone dans laquelle sont noyés des fils métalliques tous orientés selon une même direction sont également disponibles. Judicieusement masqué par le cadre opaque 56, ce connecteur souple 68 permet de relier les pistes conductrices 32, 34 portées par la face supérieure 30 du substrat arrière 16 du dispositif d'affichage à cristal liquide 12, et donc les électrodes 24 et les contre-électrodes 28, aux pistes conductrices transparentes 60 structurées sur la surface inférieure 10 de la glace 6. Par suite, un circuit imprimé flexible 36 fixé sur la surface inférieure 10 de la glace 6 et masqué par la carrure 2 permet de relier le dispositif d'affichage à cristal liquide 12 à son dispositif électronique externe 31 d'alimentation et de commande.

A la figure 6, le dispositif d'affichage à cristal liquide 12 est fixé contre la surface inférieure 10 de la glace 6 par son substrat avant 14 qui est prévu plus grand que le substrat arrière 16, ce surcroît de surface étant mis à profit pour prolonger par des premières pistes électriquement conductrices 32 les électrodes 24 portées par le substrat avant 14 hors du mur de scellement 18. De même, les contre-électrodes 28 portées par le substrat arrière 16 sont reportées sur le substrat avant 14 par exemple au moyen de billes électriquement conductrices et dispersées dans la matière du mur de scellement 18. Ces billes électriquement conductrices mettent en contact les contre-électrodes 28 avec des secondes pistes conductrices 34 qui courent sur le substrat avant 14 et qui permettent de prolonger ces électrodes 24 hors de l'enceinte étanche délimitée par le mur de scellement 18. Cela permet, quand on dispose de l'ensemble monté formé par le dispositif d'affichage à cristal liquide 12 et la glace 6, de relier par un procédé de connexion par fils encore connu sous sa dénomination anglo-saxonne wire bonding les pistes conductrices 32, 34 portées par le substrat avant 14 du dispositif d'affichage à cristal liquide 12, et donc les électrodes 24 et les contre-électrodes 28, aux pistes conductrices transparentes 60 structurées sur la surface inférieure 10 de la glace 6. Les fils de connexion 70 sont judicieusement masqués par le cadre opaque 56. Les fils de connexion 70 peuvent être remplacés par un circuit imprimé flexible. Enfin, un circuit imprimé flexible 36 fixé sur la surface inférieure 10 de la glace 6 et masqué par la carrure 2 permet de relier le dispositif d'affichage à cristal liquide 12 à son dispositif électronique externe 31 d'alimentation et de commande.

Il va de soi que la présente invention n'est pas limitée aux modes de réalisation qui viennent d'être décrits et que diverses modifications et variantes simples peuvent être envisagées par l'homme du métier sans sortir du cadre de l'invention tel que défini par les revendications annexées. En particulier, la présente invention peut être appliquée à un dispositif d'affichage à diodes organiques électroluminescentes OLED comme représenté sur la figure 7. Désigné dans son ensemble par la référence numérique générale 72, ce dispositif d'affichage OLED comprend un substrat transparent 74 qui sert de support à un empilement de couches organiques 76 pris en sandwich entre une anode 78 et une cathode 80. L'ensemble des couches du dispositif d'affichage OLED 72 est protégé de l'humidité à l'aide d'un couvercle 82 qui définit une enceinte étanche dans laquelle est agencé un dispositif absorbeur d'humidité 84. A titre de variante, l'ensemble des couches du dispositif d'affichage OLED 72 peut être protégé par dépôt de couches minces. Ces couches minces peuvent être déposées par dépôt de couches atomiques, technique mieux connue sous sa dénomination anglo-saxonne Atomic Layer Déposition ou ALD. Le dispositif d'affichage OLED est fixé contre la surface inférieure 10 de la glace 6 par son substrat transparent 74. Des pistes conductrices 86 structurées sur la face inférieure 88 du substrat transparent 74 s'étendent hors de l'enceinte étanche délimitée par le couvercle 82. Cela permet, quand on dispose de l'ensemble monté formé par le dispositif d'affichage OLED 72 et la glace 6, de relier par un procédé de connexion par fils encore connu sous sa dénomination anglo-saxonne wire bonding les pistes conductrices 86 portées par le substrat transparent 74 du dispositif d'affichage OLED 72 aux pistes conductrices transparentes 60 structurées sur la surface inférieure 10 de la glace 6. Les fils de connexion 90 sont judicieusement masqués par le cadre opaque 56. Les fils de connexion 90 peuvent être remplacés par un circuit imprimé flexible. Enfin, un circuit imprimé flexible 92 fixé sur la surface inférieure 10 de la glace 6 et masqué par la carrure 2 permet de relier le dispositif d'affichage OLED 72 à son dispositif électronique externe 94 d'alimentation et de commande agencé sur une carte de circuit imprimé 96. La zone active d'affichage 98 du dispositif d'affichage OLED 72 est définie par la zone de recouvrement entre l'anode 78 et la cathode 80. Cette zone active d'affichage 98 a un aspect métallique en l'absence de polariseur circulaire, et aura un aspect sombre si l'on utilise un tel polariseur circulaire. Conformément à l'invention, un cadre opaque 100 est ménagé sur la surface supérieure 8 de la glace 6, à distance des bords de l'ouverture 4, et recouvre la zone active d'affichage 98 du dispositif d'affichage OLED 72 à sa périphérie de façon à délimiter la surface utile à travers laquelle les informations affichées par le dispositif d'affichage OLED 72 sont perceptibles par l'utilisateur. Il subsiste donc entre les bords de l'ouverture 4 et le contour extérieur du cadre opaque 100 une zone transparente 102 dépourvue de toute information affichée à travers laquelle il est possible de voir un second dispositif d'affichage 42 tel qu'un cadran 44 au-dessus duquel se déplacent des première et seconde aiguilles 46, 48 agencé sous le dispositif d'affichage OLED 72. Dans l'exemple représenté à la figure 7, le dispositif d'affichage OLED 72 est du type à émission par le bas (bottom émission en terminologie anglo-saxonne), c'est-à-dire que la lumière émerge du dispositif d'affichage OLED 72 à travers le substrat transparent 74. Dans le cas où le dispositif d'affichage OLED 72 est du type à émission par le haut (top émission en terminologie anglo-saxonne), c'est-à-dire dans le cas où la lumière émerge du dispositif d'affichage OLED 72 du côté opposé au substrat transparent 74, il peut être envisagé de fixer le dispositif d'affichage OLED 72 contre la surface inférieure 10 de la glace 6 par l'intermédiaire de son couvercle 82. Dans le cas où le dispositif d'affichage OLED 72 est protégé de l'humidité par dépôt de couches minces sur l'ensemble de ses couches, le dispositif d'affichage OLED 72 est fixé contre la surface inférieure 10 de la glace 6 par l'intermédiaire des couches minces.

### Nomenclature

1. Boîte de montre-bracelet
2. Carrure
4. Ouverture
6. Glace
8. Surface supérieure
10. Surface inférieure
12. Dispositif d'affichage à cristal liquide
14. Substrat avant
16. Substrat arrière
18. Mur de scellement
20. Enceinte étanche
22. Cristal liquide
24. Electrodes
26. Face inférieure
28. Contre-électrodes
30. Face supérieure
31. Dispositif électronique externe d'alimentation et de commande
32. Premières pistes électriquement conductrices
34. Secondes pistes électriquement conductrices
36. Circuit imprimé flexible
37. Carte de circuit imprimé
38. Zone active d'affichage
39. Polariseur supérieur
40. Zone transparente
41. Polariseur inférieur
42. Second dispositif d'affichage
44. Cadran
46, 48. Première et seconde aiguille
50. Premier canon
52. Second canon
54. Tube creux
56. Cadre opaque
58. Carte de circuit imprimé
59. Carte de circuit imprimé transparente
60. Pistes conductrices transparentes
62. Second circuit imprimé flexible
64. Connecteur électrique
66. Troisième circuit imprimé flexible
68. Connecteur souple
70. Fils de connexion
72. Dispositif d'affichage OLED
74. Substrat transparent
76. Empilement de couches organiques
78. Anode
80. Cathode
82. Couvercle
84. Dispositif absorbeur d'humidité
86. Pistes conductrices
88. Face inférieure
90. Fils de connexion
92. Circuit imprimé flexible
94. Dispositif électronique externe d'alimentation et de commande
96. Carte de circuit imprimé
98. Zone active d'affichage
100. Cadre opaque
102. Zone transparente

## Revendications

1. Objet, en particulier un objet portable tel qu'une pièce d'horlogerie ou un téléphone intelligent, cet objet comprenant un dispositif d'affichage électrooptique délimité extérieurement par un contour et qui est muni d'un élément optiquement actif dont les propriétés optiques peuvent être modifiées par application d'un courant ou d'une tension électrique entre au moins une électrode (24) et une contre-électrode (28) correspondante entre lesquelles l'élément optiquement actif est disposé, l'objet comprenant également une carrure (2) qui délimite une ouverture (4) fermée par une glace (6), la glace (6) comprenant une surface supérieure (8) et une surface inférieure (10) sous laquelle est agencé le dispositif d'affichage électrooptique, l'objet comprenant aussi un dispositif électronique externe (31 ; 94) d'alimentation et de commande ainsi que des éléments (32, 34, 36 ; 86, 90) pour la connexion électrique du dispositif d'affichage électrooptique au dispositif électronique externe (31; 94) d'alimentation et de commande, la glace (6) étant pourvue d'un cadre opaque (56 ; 100) qui est ménagé à distance des bords de l'ouverture (4) et qui recouvre le contour du dispositif d'affichage électrooptique de façon à masquer les éléments de connexion électrique (32, 34, 36 ; 86, 90), le dispositif d'affichage électrooptique définissant une zone active d'affichage (38 ; 98) qui est circonscrite par le cadre opaque (56 ; 100), de sorte que, même lorsque le dispositif d'affichage électrooptique est activé et qu'il affiche des informations, il subsiste entre le cadre opaque (56 ; 100) et les bords de l'ouverture (4) une zone transparente (40 ; 102).

2. Objet selon la revendication 1, **caractérisé en ce qu'**il comprend un second dispositif d'affichage (42) agencé sous le dispositif d'affichage électrooptique et au moins partiellement visible à travers la zone transparente (40 ; 102).

3. Objet selon la revendication 2, **caractérisé en ce que** le second dispositif d'affichage (42) comprend un cadran (44) au-dessus duquel se déplacent des première et seconde aiguilles (46, 48).

4. Objet selon la revendication 3, **caractérisé en ce que** le dispositif d'affichage électrooptique est un dispositif d'affichage à cristal liquide (12).

5. Objet selon la revendication 4, **caractérisé en ce que** la première aiguille (46) est portée par un premier canon (50) et la seconde aiguille (48) est portée par un second canon (52) agencé concentriquement à l'intérieur du premier canon (50), le dispositif d'affichage à cristal liquide (12) étant relié au dispositif électronique externe (31) d'alimentation et de commande via un circuit imprimé flexible (36) qui est passé dans un tube creux (54) agencé à l'intérieur du second canon (52).

6. Objet selon la revendication 4, **caractérisé en ce que** le dispositif d'affichage à cristal liquide (12) est relié au dispositif électronique externe (31) d'alimentation et de commande qui est agencé sur une carte de circuit imprimé (58) disposée sous le cadran (44) grâce à un premier circuit imprimé flexible (36) qui s'étend entre le dispositif d'affichage à cristal liquide (12) et une carte de circuit imprimé transparente (59) disposée sous le dispositif d'affichage à cristal liquide (12), un second circuit imprimé flexible (60) reliant la carte de circuit imprimé transparente (59) à la carte de circuit imprimé (58) sur laquelle est agencé le dispositif électronique externe (31) d'alimentation et de commande.

7. Objet selon la revendication 4, **caractérisé en ce que** des pistes conductrices transparentes (62) sont structurées sur la surface inférieure (10) de la glace (6), le dispositif d'affichage à cristal liquide (12) étant relié à ces pistes conductrices transparentes (62) au moyen d'un premier circuit imprimé flexible (36), les pistes conductrices transparentes (62) étant elles-mêmes reliées au moyen d'un deuxième circuit imprimé flexible (60) au dispositif électronique externe (31) d'alimentation et de commande du dispositif d'affichage à cristal liquide (12) qui est masqué par la carrure (2), le second dispositif d'affichage (42) étant disposé sous le dispositif d'affichage à cristal liquide (12).

8. Objet selon la revendication 4, **caractérisé en ce que** des pistes conductrices transparentes (62) sont structurées sur la surface inférieure (10) de la glace (6), le dispositif d'affichage à cristal liquide (12) étant relié à ces pistes conductrices transparentes (62) au moyen d'un premier circuit imprimé flexible (36) et d'un deuxième circuit imprimé flexible (60) relié au premier circuit imprimé flexible (36) au moyen d'un connecteur électrique (64), un troisième circuit imprimé flexible (66) reliant les pistes conductrices transparentes (62) au dispositif électronique externe (31) d'alimentation et de commande du dispositif d'affichage à cristal liquide (12), le second dispositif d'affichage (42) étant disposé sous le dispositif d'affichage à cristal liquide (12).

9. Objet selon la revendication 4, **caractérisé en ce que** le dispositif d'affichage à cristal liquide (12) est relié à des pistes conductrices transparentes (62) structurées sur la surface inférieure (10) de la glace (6) au moyen d'un connecteur souple (68) formé d'une alternance de feuilles électriquement conductrices et de feuilles élastomères isolantes, un circuit imprimé flexible (36) permettant de relier les pistes conductrices transparentes (62) à un dispositif électronique externe (31) d'alimentation et de commande du dispositif d'affichage à cristal liquide (12), le second dispositif d'affichage (42) étant disposé sous le dispositif d'affichage à cristal liquide (12).

10. Objet selon la revendication 3, **caractérisé en ce que** le dispositif d'affichage électrooptique est un dispositif d'affichage OLED (72).

11. Objet selon la revendication 10, **caractérisé en ce que** le dispositif d'affichage OLED (72) est du type à émission par le bas et comprend un substrat transparent (74) par lequel il est fixé contre la surface inférieure (10) de la glace (6), ce substrat transparent (74) servant de support à un empilement de couches organiques (76) protégé de l'humidité à l'aide d'un couvercle (82) ou de couches minces qui définissent une enceinte étanche, des pistes conductrices (86) structurées sur une face inférieure (88) du substrat transparent (74) s'étendant hors de l'enceinte étanche et étant reliées par des fils de connexion (90) à des pistes conductrices transparentes (62) structurées sur la surface inférieure (10) de la glace (6) qui sont elles-mêmes reliées, via un circuit imprimé flexible (90), à un dispositif électronique externe (92) d'alimentation et de commande du dispositif d'affichage OLED (72).

12. Objet selon la revendication 10, **caractérisé en ce que** le dispositif d'affichage OLED (72) est du type à émission par le haut et comprend un substrat transparent (74) servant de support à un empilement de couches organiques (76) protégé de l'humidité à l'aide d'un couvercle (82) ou de couches minces qui définissent une enceinte étanche, le dispositif d'affichage OLED (72) étant fixé contre la surface inférieure (10) de la glace (6) par l'intermédiaire de son couvercle (82) ou de ses couches minces.

## Patentansprüche

1. Gebilde, insbesondere tragbares Gebilde wie etwa eine Uhr oder ein Smartphone, wobei dieses Gebilde eine elektrooptische Anzeigevorrichtung umfasst, die außen durch eine Kontur begrenzt ist und mit einem optisch aktiven Element ausgestattet ist, dessen optische Eigenschaften veränderbar sind durch Anlegen eines elektrischen Stroms oder einer elektrischen Spannung zwischen mindestens einer Elektrode (24) und einer entsprechenden Gegenelektrode (28), zwischen denen das optisch aktive Element angeordnet ist, wobei das Gebilde weiterhin einen Gehäusemittelteil (2) umfasst, der eine durch ein Glas (6) verschlossene Öffnung (4) begrenzt, wobei dieses Glas (6) eine Oberseite (8) und eine Unterseite (10) aufweist, unter der die elektrooptische Anzeigevorrichtung angeordnet ist, wobei das Gebilde ferner eine externe elektronische Versorgungs- und Steuervorrichtung (31; 94) sowie Elemente (32, 34, 36; 86, 90) für die elektrische Verbindung der elektrooptischen Anzeigevorrichtung mit der externen elektronischen Versorgungs- und Steuervorrichtung (31; 94) umfasst, und das Glas (6) mit einem opaken Rahmen (56; 60) versehen ist, der mit Abstand zu den Rändern der Öffnung (4) angeordnet ist und der die Kontur der elektrooptischen Anzeigevorrichtung derart auslegt, dass die elektrischen Verbindungselemente (32, 34, 36; 86, 90) verdeckt sind, wobei die elektrooptische Anzeigevorrichtung einen aktiven Anzeigebereich (38; 98) definiert, der von dem opaken Rahmen (56; 100) begrenzt ist, derart, dass selbst dann, wenn die elektrooptische Anzeigevorrichtung aktiviert ist und Informationen anzeigt, zwischen dem opaken Rahmen (56; 100) und den Rändern der Öffnung (4) ein transparenter Bereich (40; 102) verbleibt.

2. Gebilde nach Anspruch 1, **dadurch gekennzeichnet, dass** es eine zweite Anzeigevorrichtung (42) umfasst, die unterhalb der elektrooptischen Anzeigevorrichtung angeordnet ist und durch den transparenten Bereich (40; 102) zumindest teilweise sichtbar ist.

3. Gebilde nach Anspruch 2, **dadurch gekennzeichnet, dass** die zweite Anzeigevorrichtung (42) ein Zifferblatt (44) aufweist, über dem sich ein erster und ein zweiter Zeiger (46, 48) bewegen.

4. Gebilde nach Anspruch 3, **dadurch gekennzeichnet, dass** die elektrooptische Anzeigevorrichtung eine Flüssigkristallanzeigevorrichtung (12) ist.

5. Gebilde nach Anspruch 4, **dadurch gekennzeichnet, dass** der erste Zeiger (46) von einem ersten Rohr (50) getragen wird und der zweite Zeiger (48) von einem zweiten Rohr (52) getragen wird, das konzentrisch im Inneren des ersten Rohrs (50) angeordnet ist, wobei die Flüssigkristallanzeigevorrichtung (12) mit der externen elektronischen Versorgungs- und Steuervorrichtung (31) über eine flexible gedruckte Schaltung (36) verbunden ist, die in einem im Inneren des zweiten Rohrs (52) angeordneten Hohlrohr (54) geführt wird.

6. Gebilde nach Anspruch 4, **dadurch gekennzeichnet, dass** die Flüssigkristallanzeigevorrichtung (12) mit der externen elektronischen Versorgungs- und Steuervorrichtung (31), die auf einer unterhalb des Zifferblatts (44) angeordneten gedruckten Leiterplatte (58) angeordnet ist, verbunden ist mittels einer ersten flexiblen gedruckten Schaltung (36), die sich zwischen der Flüssigkristallanzeigevorrichtung (12) und einer unterhalb der Flüssigkristallanzeigevorrichtung (12) angeordneten transparenten gedruckten Leiterplatte (59) erstreckt, und einer zweiten flexiblen gedruckten Schaltung (60), die die transparente gedruckte Leiterplatte (59) mit der gedruckten Leiterplatte (58) verbindet, auf der die externe elektronische Versorgungs- und Steuervorrichtung (31) angeordnet ist.

7. Gebilde nach Anspruch 4, **dadurch gekennzeichnet, dass** auf der Unterseite (10) des Glases (6) transparente Leiterbahnen (62) strukturiert sind, wobei die Flüssigkristallanzeigevorrichtung (12) mit diesen transparenten Leiterbahnen (62) mittels einer ersten flexiblen gedruckten Schaltung (36) verbunden ist, und die transparenten Leiterbahnen (62) ihrerseits mittels einer zweiten flexiblen gedruckten Schaltung (60) mit der externen elektronischen Versorgungs- und Steuervorrichtung (31) der Flüssigkristallanzeigevorrichtung (12) verbunden sind, die durch den Gehäusemittelteil (2) verdeckt ist, und die zweite Anzeigevorrichtung (42) unterhalb der Flüssigkristallanzeigevorrichtung (12) angeordnet ist.

8. Gebilde nach Anspruch 4, **dadurch gekennzeichnet, dass** auf der Unterseite (10) des Glases (6) transparente Leiterbahnen (62) strukturiert sind, wobei die Flüssigkristallanzeigevorrichtung (12) mit diesen transparenten Leiterbahnen (62) mittels einer ersten flexiblen gedruckten Schaltung (36) und einer zweiten flexiblen gedruckten Schaltung (60) verbunden ist, die mit der ersten flexiblen gedruckten Schaltung (36) mittels eines elektrischen Verbinders (64) verbunden ist, und eine dritte flexible gedruckte Schaltung (66) die transparenten Leiterbahnen (62) mit der externen elektronischen Versorgungs- und Steuervorrichtung (31) der Flüssigkristallanzeigevorrichtung (12) verbindet, wobei die zweite Anzeigevorrichtung (42) unterhalb der Flüssigkristallanzeigevorrichtung (12) angeordnet ist.

9. Gebilde nach Anspruch 4, **dadurch gekennzeichnet, dass** die Flüssigkristallanzeigevorrichtung (12) mit auf der Unterseite (10) des Glases (6) strukturierten transparenten Leiterbahnen (62) mittels eines flexiblen Verbinders (68) verbunden ist, der aus elektrisch leitenden Lagen, die mit isolierenden Elastomerlagen abwechseln, gebildet ist, wobei eine flexible gedruckte Schaltung (36) ermöglicht, die transparenten Leiterbahnen (62) mit einer externen elektronischen Versorgungs- und Steuervorrichtung (31) der Flüssigkristallanzeigevorrichtung (12) zu verbinden, und die zweite Anzeigevorrichtung (42) unterhalb der Flüssigkristallanzeigevorrichtung (12) angeordnet ist.

10. Gebilde nach Anspruch 3, **dadurch gekennzeichnet, dass** die elektrooptische Anzeigevorrichtung eine OLED-Anzeigevorrichtung (72) ist.

11. Gebilde nach Anspruch 10, **dadurch gekennzeichnet, dass** die OLED-Anzeigevorrichtung (72) vom von unten emittierenden Typ ist und ein transparentes Substrat (74) umfasst, durch das sie an der Unterseite (10) des Glases (6) befestigt ist, wobei dieses transparente Substrat (74) als Träger für einen Stapel (76) organischer Schichten dient, der mit Hilfe einer Abdeckung (82) oder von Dünnschichten, die ein dichtes Gehäuse definieren, vor Feuchtigkeit geschützt ist, wobei sich Leiterbahnen (86), die auf einer Unterseite (88) des transparenten Substrats (74) strukturiert sind, außerhalb des dichten Gehäuses erstrecken und durch Verbindungsdrähte (90) mit transparenten Leiterbahnen (62) verbunden sind, die auf der Unterseite (10) des Glases (6) strukturiert sind, die ihrerseits über eine flexible gedruckte Schaltung (90) mit einer externen elektronischen Versorgungs- und Steuervorrichtung (92) der OLED-Anzeigevorrichtung (72) verbunden sind.

12. Gebilde nach Anspruch 10, **dadurch gekennzeichnet, dass** die OLED-Anzeigevorrichtung (72) vom von oben emittierenden Typ ist und ein transparentes Substrat (74) umfasst, das als Träger für einen Stapel (76) organischer Schichten dient, der mit Hilfe einer Abdeckung (82) oder von Dünnschichten, die eine dichte Abdeckung definieren, vor Feuchtigkeit geschützt ist, wobei die OLED-Anzeigevorrichtung (72) an der Unterseite (10) des Glases (6) über ihre Abdeckung (82) oder ihre Dünnschichten befestigt ist.

## Claims

1. Object, in particular a portable object such as a timepiece or smartphone, this object comprising an electro-optic display device externally delimited by a contour and which is provided with an optically active element, whose optical properties can be modified by applying an electric voltage or current between at least one electrode (24) and one corresponding auxiliary electrode (28), between which the optically active element is disposed, the object further comprising a middle part (2) which delimits an opening (4) closed by a crystal (6), the crystal (6) comprising a top surface (8) and a bottom surface (10) beneath which the electro-optic display device is arranged, the object further comprising an external electronic power and control device (31; 94) in addition to elements (32, 34, 36; 86, 90) for the electrical connection of the electro-optic display device to the external electronic power and control device (31; 94), the crystal (6) being provided with an opaque frame (56; 100) which is made remotely from the edges of the opening (4) and which covers the contour of the electro-optic display device so as to conceal the electrical connection elements (32, 34, 36; 86, 90), the electro-optic display device defining an active display area (38; 98) which is delimited by the opaque frame (56; 100), such that, even when the electro-optic display device is activated and displays information, a transparent area (40; 102) remains between the opaque frame (56; 100) and the edges of the opening (4).

2. Object according to claim 1, **characterised in that** it comprises a second display device (42) arranged beneath the electro-optic display device and at least partially visible through the transparent area (40; 102).

3. Object according to claim 2, **characterised in that** the second display device (42) comprises a dial (44) above which first and second hands (46, 48) move.

4. Object according to claim 3, **characterised in that** the electro-optic display device is a liquid crystal display device (12).

5. Object according to claim 4, **characterised in that** the first hand (46) is supported by a first pipe (50), and the second hand (48) is supported by a second pipe (52) arranged concentrically inside the first pipe (50), the liquid crystal display device (12) being connected to the external electronic power and control device (31) via a flexible printed circuit (36) which is passed in a hollow tube (54) arranged inside the second pipe (52).

6. Object according to claim 4, **characterised in that** the liquid crystal display device (12) is connected to the external electronic power and control device (31) which is arranged on a printed circuit board (58) disposed beneath the dial (44) thanks to a first flexible printed circuit (36) which extends between the liquid crystal display device (12) and a transparent printed circuit board (59) disposed beneath the liquid crystal display device (12), a second flexible printed circuit (60) connecting the transparent printed circuit board (59) to the printed circuit board (58) on which the external electronic power and control device (31) is arranged.

7. Object according to claim 4, **characterised in that** transparent conductive tracks (62) are structured on the bottom surface (10) of the crystal (6), the liquid crystal display device (12) being connected to these transparent conductive tracks (62) by means of a first flexible printed circuit (36), the transparent conductive tracks (62) being themselves connected by means of a second flexible printed circuit (60) to the external electronic power and control device (31) of the liquid crystal display device (12), which is concealed by the middle part (2), the second display device (42) being disposed beneath the liquid crystal display device (12).

8. Object according to claim 4, **characterised in that** transparent conductive tracks (62) are structured on the bottom surface (10) of the crystal (6), the liquid crystal display device (12) being connected to these transparent conductive tracks (62) by means of a first flexible printed circuit (36) and of a second flexible printed circuit (60) connected to the first flexible printed circuit (36) by means of an electrical connector (64), a third flexible printed circuit (66) connecting the transparent conductive tracks (62) to the external electronic power and control device (31) of the liquid crystal display device (12), the second display device (42) being disposed beneath the liquid crystal display device (12).

9. Object according to claim 4, **characterised in that** the liquid crystal display device (12) is connected to transparent conductive tracks (62) structured on the bottom surface (10) of the crystal (6) by means of a flexible connector (68) formed by an alternation of electrically-conductive sheets and of insulating elastomer sheets, a flexible printed circuit (36) allowing the transparent conductive tracks (62) to be connected to an external electronic power and control device (31) of the liquid crystal display device (12), the second display device (42) being disposed beneath the liquid crystal display device (12).

10. Object according to claim 3, **characterised in that** the electro-optic display device is an OLED display device (72).

11. Object according to claim 10, **characterised in that** the OLED display device (72) is of the bottom emission type and comprises a transparent substrate (74) via which it is attached to the bottom surface (10) of the crystal (6), this transparent substrate (74) acting as a support for a stack of organic layers (76) protected from humidity by a cover (82) or by thin films that define a sealed enclosure, conductive tracks (86) structured on a bottom face (88) of the transparent substrate (74) extending outside of the sealed enclosure and being connected by connecting wires (90) to transparent conductive tracks (62) structured on the bottom surface (10) of the crystal (6) which are themselves connected, via a flexible printed circuit (92), to an external electronic power and control device (94) of the OLED display device (72).

12. Object according to claim 10, **characterised in that** the OLED display device (72) is of the top emission type and comprises a transparent substrate (74) acting as a support for a stack of organic layers (76) protected from humidity by a cover (82) or by thin films that define a sealed enclosure, the OLED display device (72) being attached to the bottom surface (10) of the crystal (6) via the cover (82) thereof or via the thin films thereof.
